# EUROPEAN PATENT APPLICATION

(11) **EP 4 436 328 A1**
(43) Date of publication of application: **25.09.2024**
(21) Application number: 23211599.8
(22) Date of filing: 22.11.2023
(51) Int. Cl.: H10B 12/00

(54) **SEMICONDUCTOR MEMORY DEVICES AND METHODS OF FABRICATING THE SAME**

(30) Priority: 20.03.2023 KR 20230035922
(71) Applicant: Samsung Electronics Co., Ltd., Suwon-si, Gyeonggi-do 16677 (KR)
(72) Inventor: WON, Seokjae, 16677 Suwon-si (KR); KANG, Yoongoo, 16677 Suwon-si (KR); PARK, Jaehong, 16677 Suwon-si (KR)
(74) Representative: Marks & Clerk LLP

(57) **Abstract**

A semiconductor device includes a device isolation part on a substrate, the device isolation part defining a first active portion and a second active portion, with a center portion of the first active portion adjacent in a first direction to an edge portion of the second active portion. A first impurity region is in the center portion of the first active portion, and a second impurity region is in the edge portion of the second active portion. A first bit line is in direct contact with the first impurity region and extends across the substrate in a second direction that intersects the first direction. A storage node contact is in contact with the second impurity region, with an upper sidewall and a lower sidewall of the storage node contact on a common side of the storage node contact not vertically aligned with each other.

## Description

### TECHNICAL FIELD

The present disclosure relates to semiconductor memory devices and to methods of fabricating semiconductor memory devices.

### BACKGROUND

Due to their small sizes, multifunctionality, and/or low cost, semiconductor devices are used throughout the electronic industries. Higher integration of semiconductor memory devices is desired to satisfy consumer demands for superior performance and inexpensive prices. In the case of semiconductor memory devices, increased integration is desired because integration can affect product prices. Thus, recently a variety of studies on new technology have been conducted to increase the density of semiconductor memory devices.

### SUMMARY

Some aspects of the present disclosure provide semiconductor memory devices with improved reliability.

Some aspects the present disclosure provide methods of fabricating semiconductor memory devices in a way that reduces defects thereof.

A semiconductor memory device according to some embodiments of the present invention includes a device isolation part on a substrate, the device isolation part defining a first active portion and a second active portion, with a center portion of the first active portion adjacent in a first direction to an edge portion of the second active portion. A first impurity region is in the center portion of the first active portion, a second impurity region is in the edge portion of the second active portion, a first bit line is in direct contact with the first impurity region and extends across the substrate in a second direction that intersects the first direction (e.g. wherein the first and second directions are different), and a storage node contact is in contact with the second impurity region. An upper end of the first impurity region is higher than an upper end of the second impurity region, and an upper sidewall of the storage node contact is not vertically aligned with a lower sidewall of the storage node contact, where the upper sidewall and the lower sidewall are both on a common side of the storage node contact.

A semiconductor memory device according to some embodiments of the present disclosure may include a device isolation part on a substrate and defining a first active portion and a second active portion, with a center portion of the first active portion adjacent in a first direction to an edge portion of the second active portion. A first impurity region may be in the center portion of the first active portion, a second impurity region may be in the edge portion of the second active portion, a first bit line may be in direct contact with the first impurity region and may extend across the substrate in a second direction that intersects the first direction (e.g. wherein the first and second directions are different), a storage node contact may be in contact with the second impurity region, and a second bit line may be spaced apart from the first bit line in the first direction. The storage node contact may be interposed between the second bit line and the first bit line, an interlayer insulating layer may be interposed between the second bit line and the device isolation part, and a separation spacer may be interposed between an upper sidewall of the device isolation part and a lower portion of the storage node contact. A lower surface of the separation spacer may have a first level, and a lower surface of the interlayer insulating layer may have a second level equal to or lower than the first level.

A semiconductor memory device according to some embodiments of the present disclosure may include a device isolation part on a substrate and defining a first active portion and a second active portion, with a center portion of the first active portion adjacent in a first direction to an edge portion of the second active portion. A word line may be in the substrate and may extend across the first active portion in the first direction, with the second active portion free from overlap with the word line. A word line capping pattern may be on the word line, a first impurity region may be in the center portion of the first active portion, a second impurity region may be in the edge portion of the second active portion, a first bit line may be in direct contact with the first impurity region and may extend across the substrate in a second direction that intersects the first direction (e.g. wherein the first and second directions are different), a storage node contact may be in contact with the second impurity region, a landing pad may be on the storage node contact, and a second bit line may be spaced apart from the first bit line in the first direction. The storage node contact may be interposed between the second bit line and the first bit line, a bit line spacer may be interposed between the storage node contact and the second bit line, an interlayer insulating layer may be interposed between the second bit line and the device isolation part, and a separation spacer maybe interposed between an upper sidewall of the device isolation part and a lower portion of the storage node contact. The storage node contact may include a first silicon pattern and a second silicon pattern sequentially stacked, where the first silicon pattern includes first silicon grains having a first average grain size, and the second silicon pattern includes second silicon grains having a second average grain size greater than the first average grain size. The first silicon pattern may be between the separation spacer and the interlayer insulating layer, and the second silicon pattern may be between the first bit line and the second bit line.

A method of fabricating semiconductor memory device according to some embodiments of the present disclosure may include: forming a device isolation part on a substrate that defines a first active portion and a second active portion, with a center portion of the first active portion adjacent in a first direction to an edge portion of the second active portion; forming a first impurity region in the center portion of the first active portion and forming a second impurity region in the edge portion of the second active portion; forming a trench by etching a portion of the substrate where the second impurity region is formed and a portion of the device isolation part; forming a separation spacer on an inner wall of the trench; forming an interlayer insulating layer in the trench that overlaps the device isolation part; forming a buried sacrificial layer in the trench between the interlayer insulating layer and the separation spacer and in contact with the second impurity region; forming a first bit line in contact with the first impurity region and a second bit line in contact with the interlayer insulating layer; forming a bit line spacer on sidewalls of the first bit line and the second bit line; removing the buried sacrificial layer to expose the second impurity region; and forming a storage node contact in contact with the second impurity region and between the first bit line and the second bit line.

A method of fabricating semiconductor memory device according to some embodiments of the present disclosure may include: forming a device isolation part on a substrate, the device isolation part defining a first active portion and a second active portion, where a center portion of the first active portion is adjacent in a first direction to an edge portion of the second active portion; forming a first impurity region in the center portion of the first active portion and forming a second impurity region in the edge portion of the second active portion; forming a trench by etching a portion of the substrate where the second impurity region is formed and by etching a portion of the device isolation part; forming a separation spacer on an inner wall of the trench; forming an interlayer insulating layer in the trench that overlaps the device isolation part; forming a first silicon pattern in the trench between the interlayer insulating layer, the separation spacer and in contact with the second impurity region; forming a first bit line in contact with the first impurity region and a second bit line in contact with the interlayer insulating layer; forming a bit line spacer on sidewalls of the first bit line and the second bit line; and forming a second silicon pattern in contact with the first silicon pattern and between the first bit line and the second bit line.

At least some of the above and other features of the invention are set out in the claims.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIG. 1A is a plan view of a semiconductor device according to some embodiments of the present disclosure.
FIG. 1B is a cross-sectional view of the semiconductor device of FIG. 1A, taken along lines A-A' and line B-B'.
FIG. 2A is an enlarged view of portion 'P1' of FIG. 1A.
FIGS. 2B and 2C are enlarged views of portion 'P2' of FIG. 1B according to some embodiments.
FIGS. 3A, 4A, 5A, 6A, 8A, 9A, 10A, 11A, and 12 are plan views sequentially illustrating a process of fabricating the semiconductor memory device of FIGS. 1A and 1B.
FIGS. 3B, 4B, 5B, 6B, 7, 8B, 9B, 10B, and 11B are cross-sectional views taken along lines A-A' and B-'B of FIG. 1A sequentially illustrating a process of fabricating the semiconductor memory device of FIGS. 1A and 1B.
FIG. 13 is a cross-sectional view of FIG. 1A taken along line A-A' and line B-B' according to some embodiments of the present disclosure.
FIGS. 14A and 14B are enlarged views of portion 'P3' of FIG. 13 according to some embodiments.
FIGS. 15A, 16A, and 17A are plan views illustrating a process of fabricating a semiconductor memory device according to some embodiments of the present disclosure.
FIGS. 15B, 16B, and 17B are cross-section views taken along lines A-A' and B-B' of FIGS. 15A, 16A, and 17A, illustrating a process of fabricating a semiconductor memory device according to some embodiments of the present disclosure.

### DETAILED DESCRIPTION

Hereinafter, to explain the present disclosure in more detail, some examples of embodiments according to the present disclosure will be described in more detail with reference to the accompanying drawings.

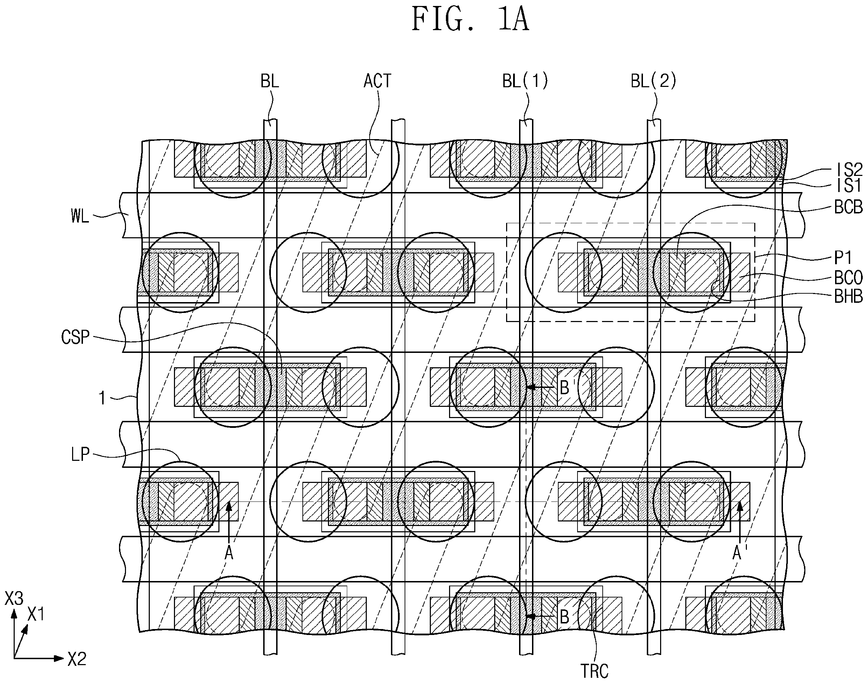

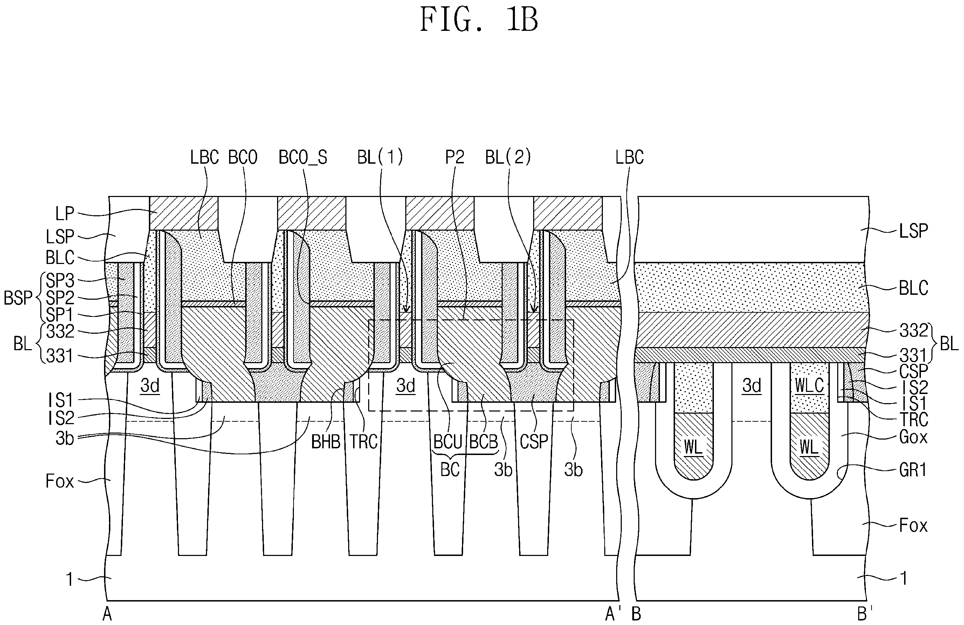

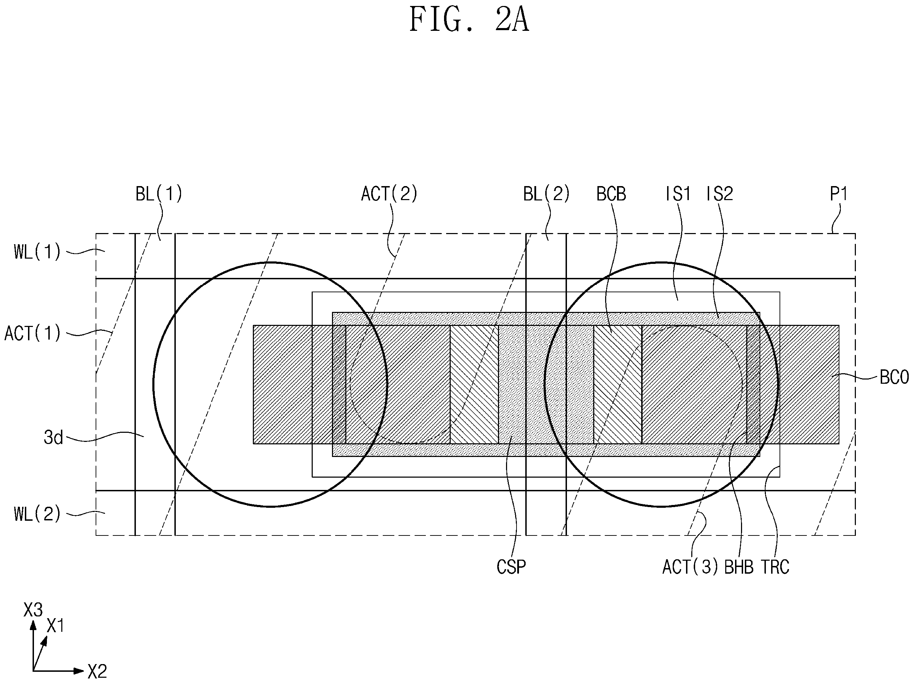

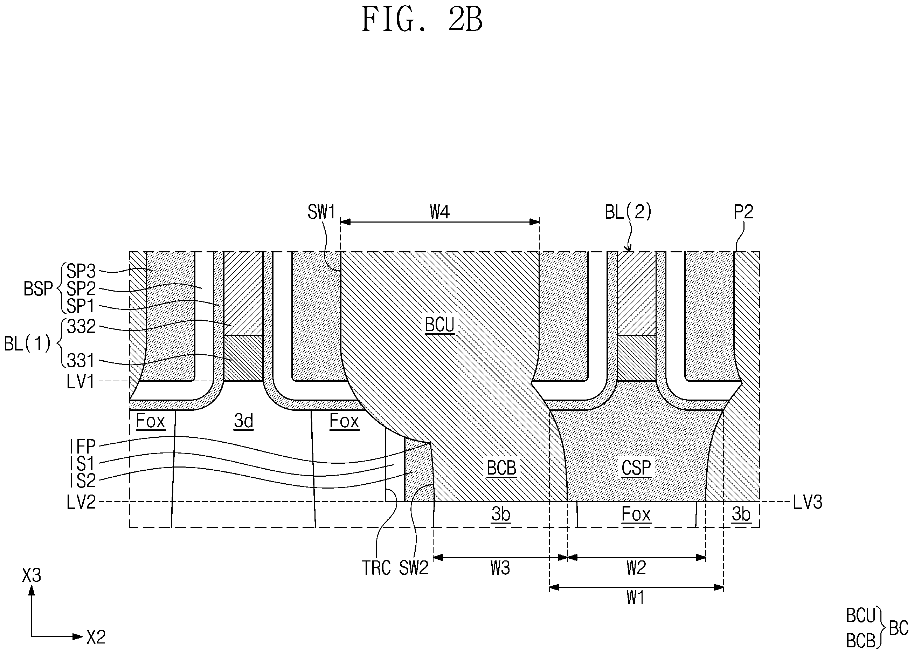

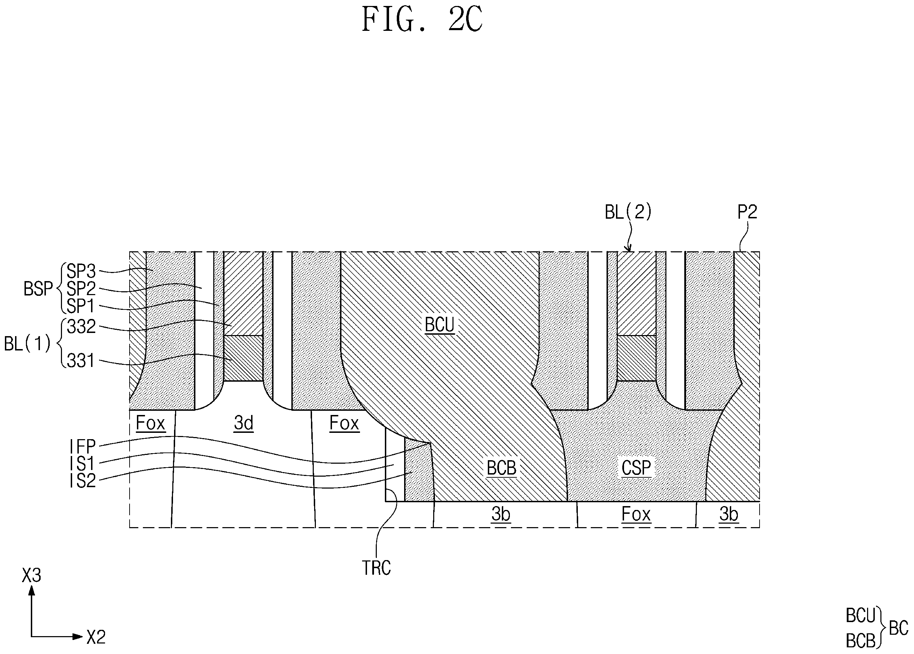

FIG. 1A is a plan view of a semiconductor device according to some embodiments of the present disclosure. FIG. 1B is a cross-sectional view of the semiconductor device of FIG. 1A taken along line A-A' and line B-B'. FIG. 2A is an enlarged view of portion 'P1' of FIG. 1A. FIGS. 2B and 2C are enlarged views of portion 'P2' of FIG. 1B according to some embodiments.

Referring to FIGS. 1A and 1B, device isolation parts Fox may be provided on a substrate 1 and define active portions ACT. Each of the active portions ACT may have an isolated shape. As seen in the plan view of FIG. 1A, each of the active portions ACT may have a bar shape that is elongated in a first direction X1. When viewed in the plan view, the active portions ACT may respectively correspond to portions of the substrate 1 surrounded by the device isolation parts Fox. The substrate 1 may include a semiconductor material. The active portions ACT may be arranged parallel to each other in the first direction X1, and an end of one active portion ACT may be arranged adjacent to a center of other active portions ACT adjacent thereto. Each of the device isolation parts Fox may include, for example, a single layer or multilayer structure of at least one of silicon oxide, silicon oxynitride, and silicon nitride.

Word lines WL may cross the active portions ACT. The word lines WL may be in grooves GR1 formed in the device isolation part Fox and the active portions ACT. The word lines WL may be parallel to a second direction X2 that crosses or intersects the first direction X1 (e.g. wherein the first and second directions X1 and X2 are different). The word lines may be spaced apart from each other in a third direction X3 that crosses the first direction X1 and the second direction X2 (e.g. wherein the first, second and third directions X1, X2 and X3 are different and wherein, in some embodiments, the third direction X3 is perpendicular to the second direction X2). The word lines WL may be formed of a conductive material. Each active portion ACT may be crossed by two word lines WL. A gate dielectric layer Gox may be between each of the word lines WL and an inner surface of each of the grooves GR1.

Although not shown, bottoms of the grooves GR1 may be relatively deep in the device isolation parts Fox and relatively shallow in the active portions ACT. Bottom surfaces of the word lines WL may be curved. The gate dielectric layer Gox may include at least one of a thermal oxide, silicon nitride, silicon oxynitride, and a high dielectric material, and preferably may include a thermal oxide.

A first impurity region 3d may be in each of the active portions ACT between the two word lines WL adjacent to each other in the third direction X3 that cross thereto (e.g., at a center of each of the active portions ACT). Each of a pair of second impurity regions 3b may be in a respective edge region of each of the active portions ACT. In other words, one of the pair of second impurity regions 3b may be in a first edge region of an active portion ACT on a same first side of the two word lines WL crossing the active portion ACT, the other of the pair of second impurity regions 3b may be in a second edge region of the active portion ACT on a same second side of the two word lines WL crossing the active portion ACT. The first and second impurity regions 3d and 3b may be doped with, for example, N-type impurities. The first impurity region 3d may correspond to a common drain region and each of the second impurity regions 3b may correspond to a source region. Each of the word lines WL and the first and second impurity regions 3d and 3b adjacent thereto may constitute a transistor. As the word lines WL are provided in the grooves GR1, a channel length of a channel area under the word lines WL may be increased within a limited plane area. Therefore, the short-channel effect and the like may be minimized.

A word line capping pattern WLC may be on each of the word lines WL. The word line capping pattern WLC may have a line shape that extends in a length direction of the word lines WL and may cover the entire upper surfaces of the word lines WL. The word line capping pattern WLC may be in a portion of (e.g., may fill a portion of) the grooves GR1 on the word lines WL. The word line capping pattern WLC may be formed of, for example, a silicon nitride layer.

Bit lines BL may be arranged on the substrate 1. The bit lines BL may cross the word line capping pattern WLC and the word lines WL. As shown in FIG. 1A, the bit lines BL may be parallel to the third direction X3 that crosses first and second directions X1 and X2 (e.g. wherein the third direction X3 is different to the first and second directions X1 and X2).

The bit line BL may include a first bit line metal pattern 331 and a second bit line metal pattern 332 that are sequentially stacked. The first bit line metal pattern 331 may include at least one of cobalt silicide, titanium silicide, titanium, titanium nitride (TiN), titanium silicon nitride (TiSiN), tantalum, tantalum nitride, and/or tungsten nitride. The second bit line metal pattern 332 may include, for example, a metal such as tungsten, aluminum, or copper. Although not shown, the bit line BL may further include a polysilicon pattern doped with impurities under the first bit line metal pattern 331.

Each of sidewalls of the bit lines BL may be covered with a bit line spacer BSP. The bit line spacer BSP may include first to third sub bit line spacers (or sub-spacers) SP1, SP2, and SP3 sequentially arranged outward from the sidewall of each bit line BL. The first to third sub bit line spacers SP1, SP2, and SP3 may be independently formed of one of silicon oxide, silicon nitride, and silicon oxynitride. For example, the second sub bit line spacer SP2 may be formed of a material different from that of the first and third sub bit line spacers SP1 and SP3. In some embodiments, each of the first and second sub bit line spacers SP1 and SP2 may have an 'L'-shaped cross section as shown in FIG. 2B. Portions of the first and second sub bit line spacers SP1 and SP2 may extend to cover a lower surface of the third sub bit line spacer SP3. Alternatively, in some embodiments, each of the first and second sub bit line spacers SP1 and SP2 may have an 'I'-shaped cross section as shown in FIG. 2C, and the third sub bit line spacer SP3 may directly contact a device isolation part Fox and a first impurity region 3d.

A bit line capping pattern BLC may be on the bit lines BL. The bit line capping pattern BLC may have a single layer or multilayer structure of at least one of silicon oxide, silicon nitride, and silicon oxynitride. A side surface of the bit line capping pattern BLC may be covered with the bit line spacer BSP.

A lower surface of the bit line BL may be flat. The bit line BL may be in direct contact with the first impurity region 3d. Therefore, in the present disclosure, there is no bit line contact plug disposed between the bit line BL and the first impurity region 3d. As a result, it is not necessary to form a bit line contact plug, which simplifies the fabricating process and reduces the difficulty of the process. In addition, as there is no bit line contact plug, a path between the bit line and the first impurity region 3d may be shortened and electrical resistance may be reduced, bit line necking cut or bit line to buried contact disturb (BBD) defects may be improved, thereby improving reliability of the semiconductor memory device.

Referring to FIGS. 2A and 2B, the active portions ACT include first to third active portions ACT(1) to ACT(3) disposed side by side in the second direction X2. The word lines WL include first and second word lines WL(1) and WL(2) spaced apart from each other in the third direction X3. The first word line WL(1) passes through the first and second active portions ACT(1) and ACT(2), but does not pass through the third active portion ACT(3). The second word line WL(2) passes through the first and third active portions ACT(1) and ACT(3), but does not pass through the second active portion ACT(2). A trench TRC is formed in the substrate 1 and the device isolation part Fox. Trenches TRC may be between word lines WL. Two second impurity regions 3b adjacent to each other may be on the bottom surface of the trench TRC. The second impurity region 3b at the end of the second active portion ACT(2) and the second impurity region 3b at the end of the third active portion ACT(3) may be on the bottom surface of one of the trenches TRC (3b).

An upper end of the first impurity region 3d has a first level LV1. An upper end of second impurity region 3b has a second level LV2 lower than the first level LV1. As a result, the upper end of the first impurity region 3d may be farther away from the upper end of the second impurity region 3b, and thus the bit line to buried contact disturbance (BBD) defect may be improved.

An inner wall of the trench TRC may be covered with inner spacers IS1 and IS2. The inner spacers IS1 and IS2 may be a separation spacer. Each of the inner spacers IS 1 and IS2 may have a rectangular ring shape when viewed in a plan view, as shown in FIG. 2A. The inner spacers IS1 and IS2 include a first inner spacer IS1 that is in contact with the inner wall of the trench TRC and a second inner spacer IS2 that covers the first inner spacer IS 1. A level of an upper end of the first inner spacer IS1 may be higher than a level of an upper end of the second inner spacer IS2. Each of the first inner spacer IS1 and the second inner spacer IS2 may independently have a structure of at least one single layer or multilayer selected from among silicon oxide, silicon nitride, and silicon oxynitride. The first inner spacer IS1 and the second inner spacer IS2 may be formed of materials having etch selectivities with respect to each other. For example, the first inner spacer IS1 may be formed of silicon oxide and the second inner spacer IS2 may be formed of silicon nitride. Lower surfaces of the first inner spacer IS1 and the second inner spacer IS2 may have the second level LV2. The use of such inner spacers IS1 and IS2 may improve the bit line to buried contact disturb (BBD) defects.

The bit lines BL may include a first bit line BL(1) and a second bit line BL(2). The first bit line BL(1) may be in contact with the first impurity region 3d in the center of the first active portion ACT(1). The second bit line BL(2) overlaps the device isolation part Fox between the second impurity regions 3b on the bottom surface of the trench TRC.

An interlayer insulating layer CSP may be between the second bit line BL(2) and the device isolation part Fox at the center of the trench TRC. The interlayer insulating layer CSP may be formed of the same material as that of the second inner spacer IS2. For example, the interlayer insulating layer CSP may have a structure of at least one single layer or multiple layers selected from among silicon oxide, silicon nitride, and silicon oxynitride, and preferably may be formed of silicon nitride. In the cross sectional view of FIG. 1B taken along line B-B' of FIG. 1A, a portion of the lower surface of the bit line BL may be in contact with an upper surface of the word line capping pattern WLC and an upper surface of the interlayer insulating layer CSP.

A width of the interlayer insulating layer CSP may decrease as it goes downward (toward a bottom surface of the substrate 1). An upper portion of the interlayer insulating layer CSP may have a first width W1 in the second direction X2, and a lower portion of the interlayer insulating layer CSP may have a second width W2 smaller than the first width W1. A side surface of the interlayer insulating layer CSP may be rounded. An upper end of the interlayer insulating layer CSP may have the first level LV1. A lower surface of the interlayer insulating layer CSP may have a third level LV3. The third level LV3 may be equal to or lower than the second level LV2. This feature may improve the bit line necking cut or the bit line to buried contact disturb (BBD) defects.

Storage node contacts BC in contact with the second impurity region 3b may be between the bit lines BL. The storage node contacts BC may include an upper portion BCU and a lower portion BCB. There may be no boundary line between the upper portion BCU and the lower portion BCB of the storage node contact BC, and the upper portion BCU and the lower portion BCB may be integrally formed with each other. A sidewall SW1 of the upper portion BCU of the storage node contact BC is not vertically aligned with a sidewall SW2 of the lower portion BCB of the storage node contact BC. The sidewall SW1 and the sidewall SW2 may both be on a common side of the storage node contact BC. The sidewall SW1 and the sidewall SW2 may face a bit line BL and a bit line spacer BSP thereon. The sidewall SW2 of the lower portion BCB of the storage node contact BC may be rounded. Side surfaces of the storage node contacts BC may each have an inflection point IFP between the upper portion BCU and the lower portion BCB. The lower portion BCB of the storage node contact BC may have a third width W3 in the second direction X2. The upper portion BCU of the storage node contact BC may have a fourth width W4 greater than the third width W3 in the second direction X2. The lower portion BCB of the storage node contact BC may be inserted below the bit line spacer BSP covering the sidewall of the second bit line BL. Lower surfaces of the storage node contacts BC may be planar. The lower surfaces of the storage node contacts BC may have the second level LV2. The upper portion BCU of the storage node contact BC may be offset from the lower portion BCB of the storage node contact BC in the second direction X2. As a result of the upper portion of the interlayer insulating layer CSP having a first width W1 in the second direction X2 and the lower portion of the interlayer insulating layer CSP having a second width W2 smaller than the first width W1, an area of the storage node contact BC may increase thereby resulting in a decrease in a contact resistance between the storage node contact BC and the substrate 1.

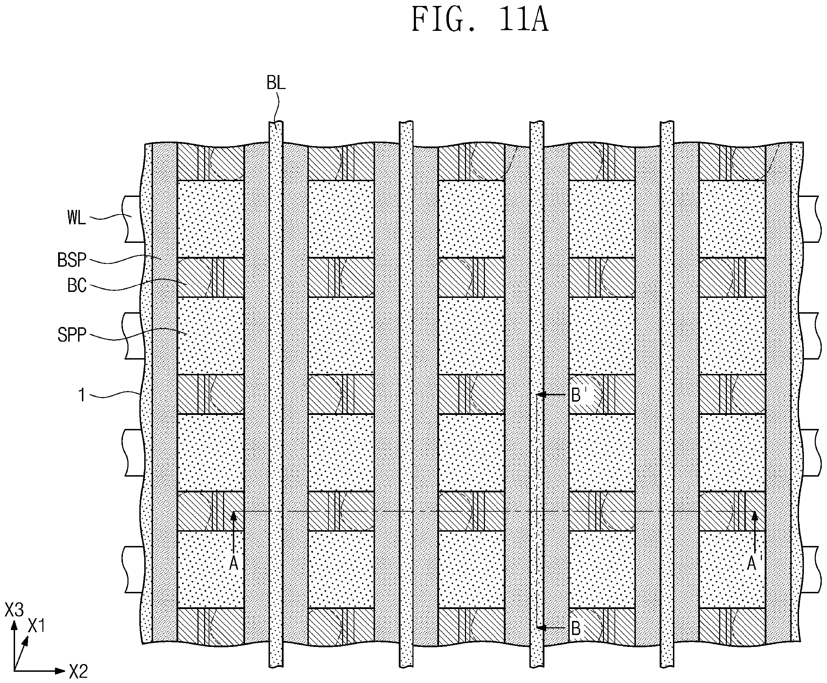

As shown in FIG. 11A, in some embodiments storage node separation patterns SPP may be between the storage node contacts BC in the third direction X3. The storage node separation pattern SPP may have a single layer or multilayer structure of at least one of silicon oxide, silicon nitride, and silicon oxynitride.

As shown in FIG. 1B, an ohmic pattern BCO, a contact metal pattern LBC, and a landing pad LP may be sequentially provided on the storage node contact BC. The ohmic pattern BCO may be formed of, for example, a metal silicide such as cobalt silicide, titanium silicide, or tungsten silicide. A sidewall BCO_S of the ohmic pattern BCO is not aligned with the sidewall SW2 of the lower portion BCB of the storage node contact BC. The ohmic pattern BCO may overlap the inner spacers IS1 and IS2 when viewed in a plan view.

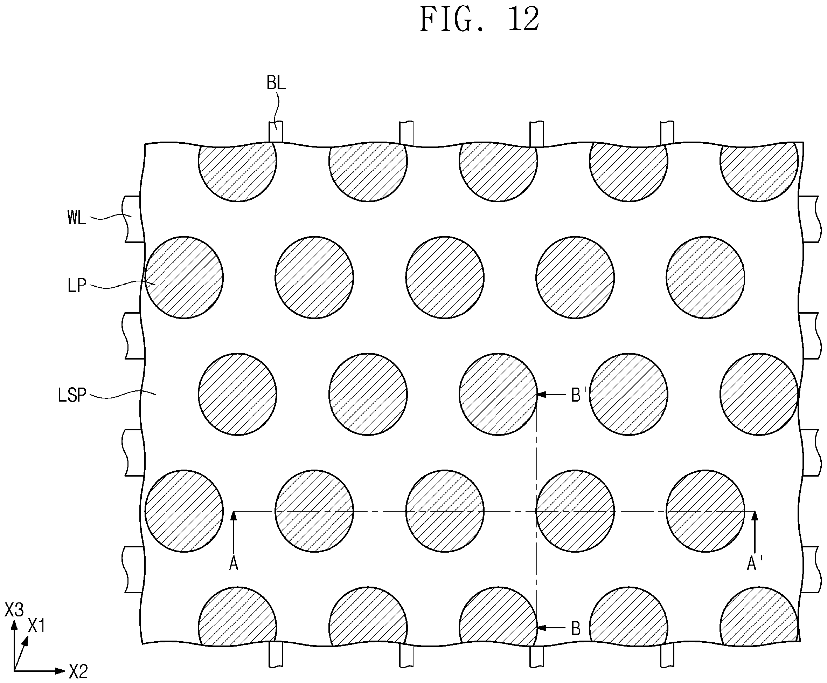

The contact metal pattern LBC and the landing pad LP may be formed of the same or different metals. When the contact metal pattern LBC and the landing pad LP are formed of the same material, there may be no boundary between the contact metal pattern LBC and the landing pad LP, and the contact metal pattern LBC and the landing pad LP may be integrally formed at the same time. The landing pad LP may cover the bit line capping pattern BLC. In some embodiments, when viewed in a plan view as seen in FIG. 12, the landing pads LP may have island shapes spaced apart from each other. Six landing pads LP may be arranged with a seventh landing pad LP at the center thereof and may form a regular hexagonal shape. The landing pads LP may be arranged to form a honeycomb shape.

As shown in FIG. 1B, a landing pad separation pattern LSP may be between the landing pads LP. The landing pad separation pattern LSP may have a single layer or multilayer structure of at least one of silicon oxide, silicon nitride, and/or silicon oxynitride. A portion of the landing pad separation pattern LSP may pass through portions of the bit line capping pattern BLC and the bit line spacer BSP.

Although not shown, data storage patterns may be on each of the landing pads LP. The data storage patterns may be capacitors each including a lower electrode, a dielectric layer, and an upper electrode. In this case, the semiconductor memory device may be a dynamic random-access memory (DRAM). Alternatively, the data storage patterns may include magnetic tunnel junction patterns. In this case, the semiconductor memory device may be a magnetic random access memory (MRAM). Alternatively, the data storage patterns may include a phase change material or a variable resistance material. In this case, the semiconductor memory device may be a phase-change random access memory (PRAM) or a resistive RAM (ReRAM).

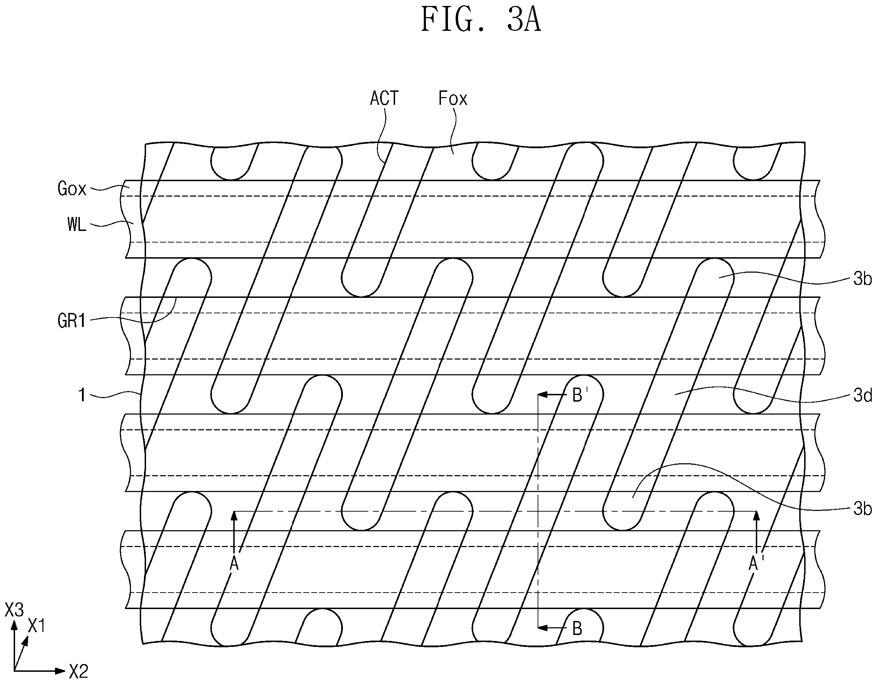

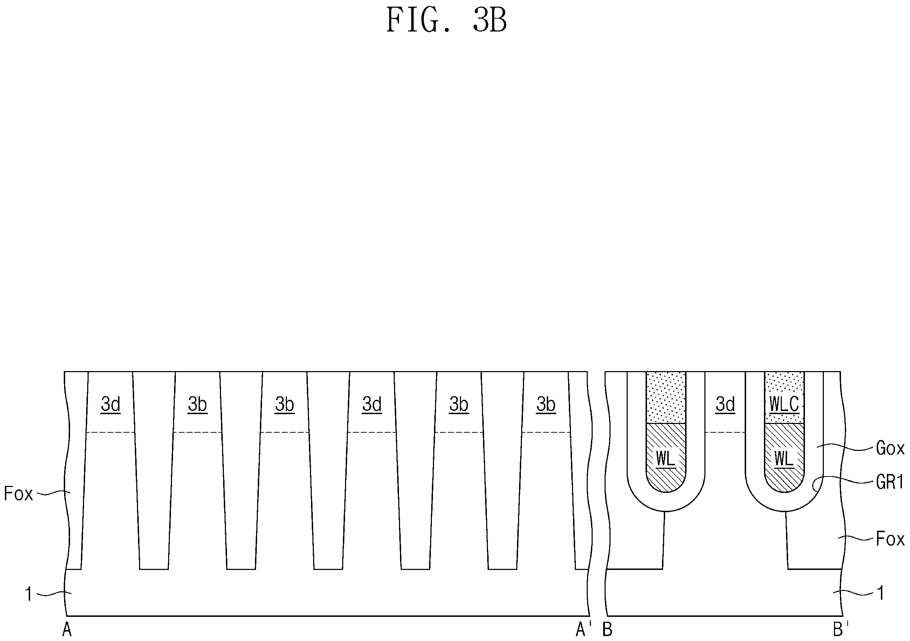

FIGS. 3A, 4A, 5A, 6A, 8A, 9A, 10A, 11A, and 12 are plan views sequentially illustrating a process of fabricating the semiconductor memory device of FIGS. 1A and 1B. FIGS. 3B, 4B, 5B, 6B, 7, 8B, 9B, 10B, and 11B are cross-sectional views sequentially illustrating a process of fabricating the semiconductor memory device taken along lines A-A' and B-B' of FIG. 1A.

Referring to FIGS. 3A and 3B, active portions ACT may be defined by forming device isolation parts Fox on a substrate 1. A device isolation trench may be formed in the substrate 1, and the device isolation part Fox may be provided in (and in some embodiments may fill) the device isolation trench. Grooves GR1 may be formed by patterning the active portions ACT and the device isolation part Fox. In this case, etching conditions for the substrate 1 and the device isolation part Fox may be adjusted such that the device isolation part Fox is more easily etched than the substrate 1. As a result, bottom surfaces of the grooves GR1 may be curved.

A gate dielectric layer Gox may be formed in and conform to the grooves GR1. The gate dielectric layer Gox may be formed through a thermal oxidation process, a chemical vapor deposition process, and/or an atomic layer deposition process. A gate conductive layer may be stacked in the grooves GR1 and may fill a portion thereof, and the gate conductive layer may be etched back to form word lines WL. A pair of the word lines WL may cross each of the active portions ACT. An insulating layer such as, for example, a silicon nitride layer may be stacked on the substrate 1 in the grooves GR1 and may fill a portion thereof, and then may be etched to form a word line capping pattern WLC on each of the word lines WL. First and second impurity regions 3d and 3b may be formed by implanting dopants into the active regions ACT using the word line capping pattern WLC and the device isolation region Fox as a mask.

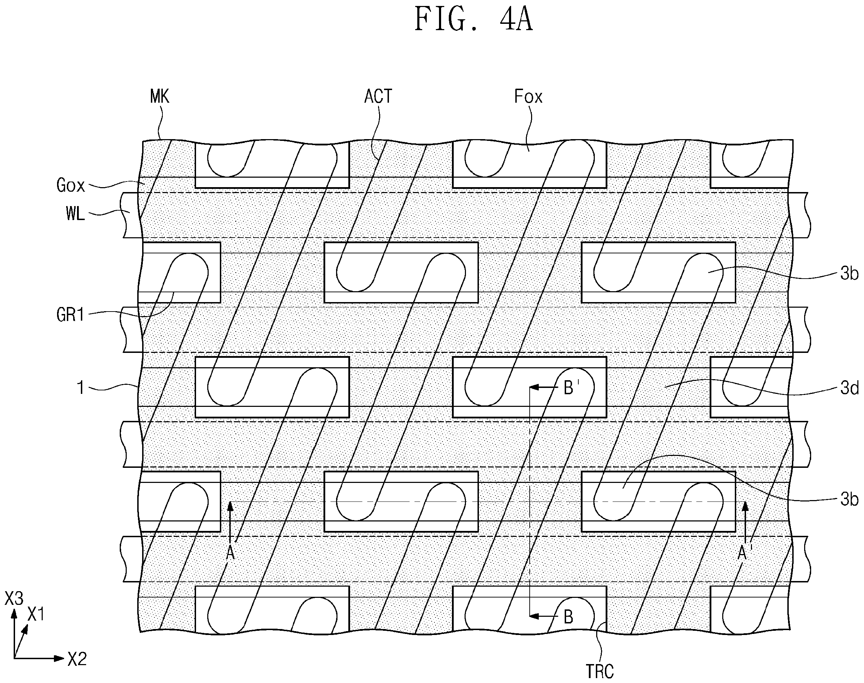

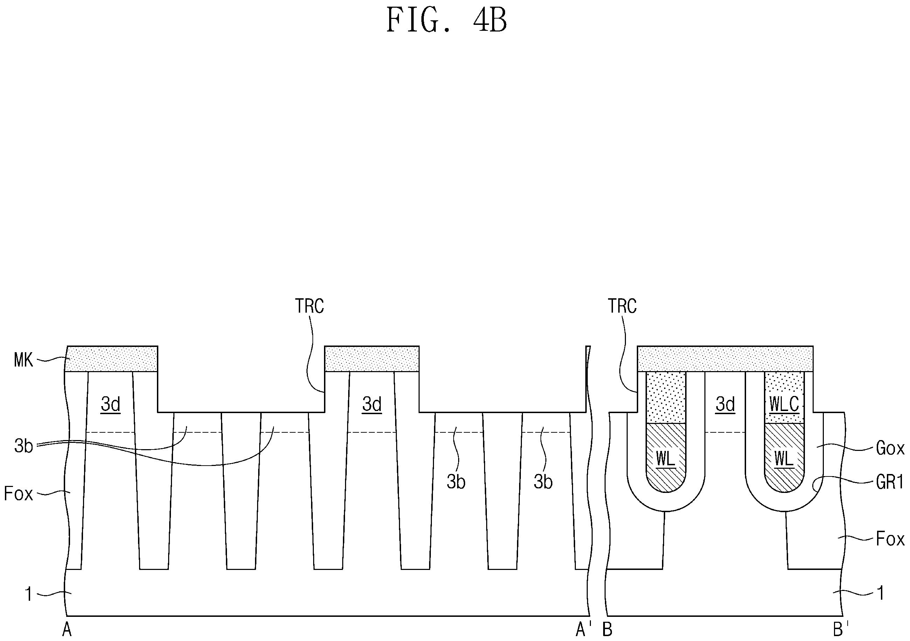

Referring to FIGS. 4A and 4B, a mask pattern MK may be formed on the entire surface of the substrate 1. The mask pattern MK may include openings exposing the second impurity regions 3b adjacent to each other in the second direction X2. The mask pattern MK may have a single layer or multilayer structure of at least one of silicon nitride, silicon germanium, and/or photoresist. The substrate 1 and the device isolation part Fox may be etched using the mask pattern MK as an etching mask to form trenches TRC.

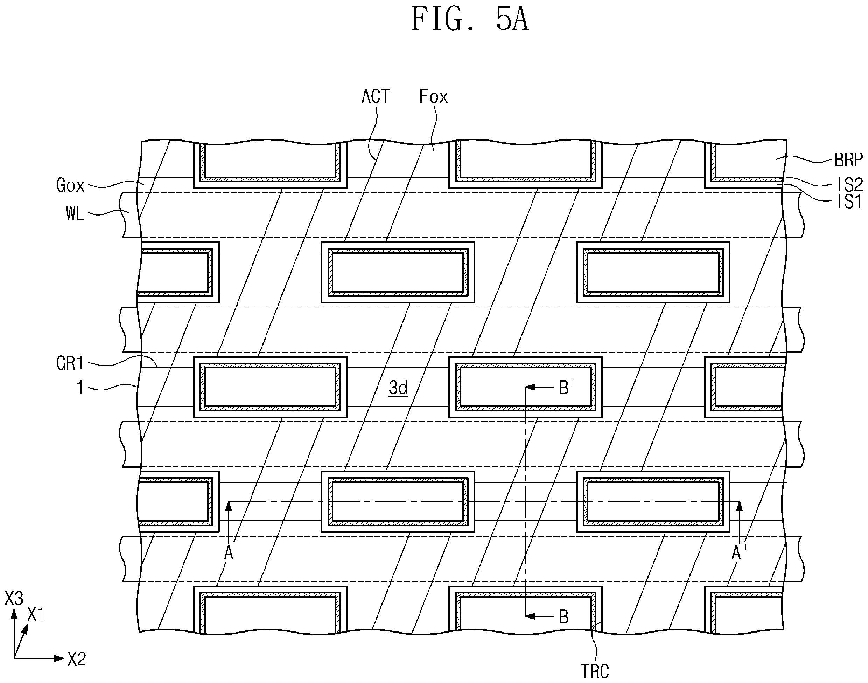

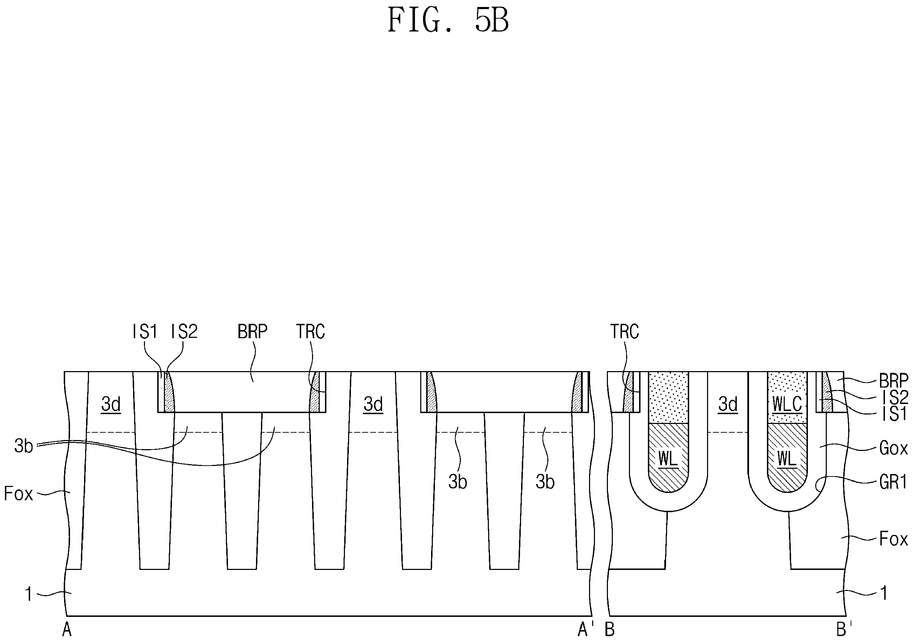

Referring to FIGS. 5A and 5B, first inner spacers IS1 may be formed that may cover inner walls of the trenches TRC. A second inner spacer IS2 may be formed that may cover the sidewall of the first inner spacer IS1. The trenches may be filled with a buried sacrificial layer BRP. After filling the trenches TRC with the buried sacrificial layer BRP, a front surface etch-back process or a chemical mechanical polishing (CMP) process may be performed to remove the mask pattern MK and to expose and the device isolation part Fox and an upper surface of the substrate 1. As a result, first and second inner spacers IS1 and IS2 and a filling sacrificial layer BRP may be formed in the trenches TRC. An outer wall of the second inner spacer IS2 may be formed to be rounded. The outer wall of the second inner spacer IS2 may face toward a center of the trench TRC. The buried sacrificial layer BRP may be formed of a material having etch selectivity with at least the second inner spacer IS2. The buried sacrificial layer BRP may be formed of, for example, silicon oxide, SiC, silicon germanium, polysilicon, or amorphous carbon layer (ACL).

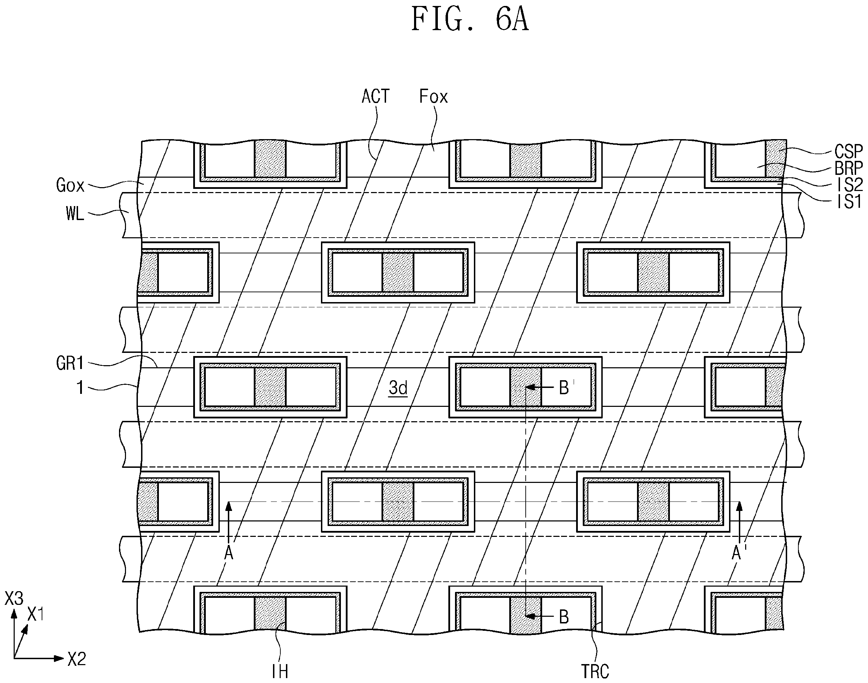

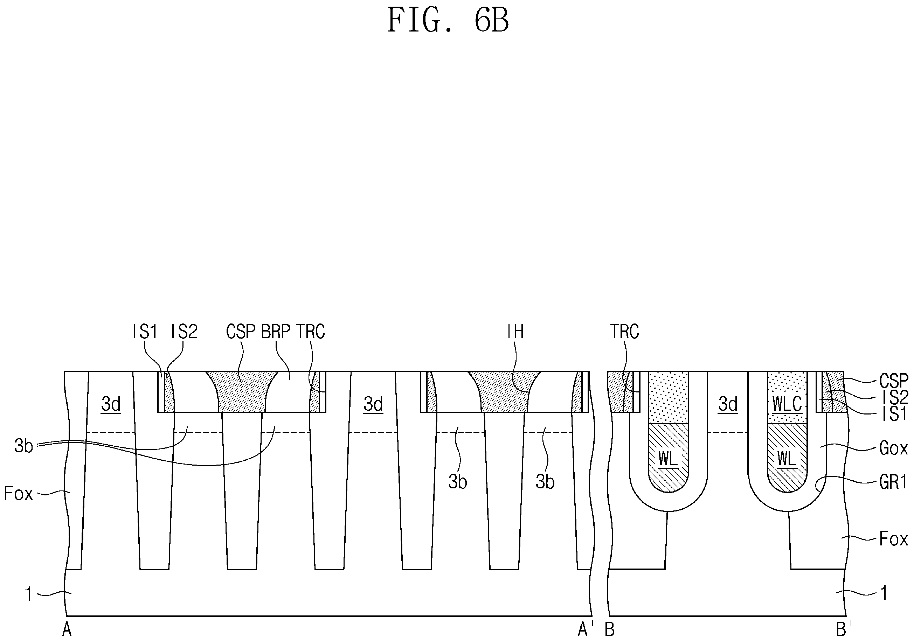

Referring to FIGS. 6A and 6B, a portion of the buried sacrificial layer BRP at a center of the trench TRC may be removed to form an inner hole IH that exposes the device isolation part Fox, the inner hole IH may be filled with an insulating material and etched back to form an interlayer insulating layer CSP. The interlayer insulating layer CSP may be formed of a material having etch selectivity with the buried sacrificial layer BRP, for example, silicon nitride. The interlayer insulating layer CSP may be spaced apart from the second inner spacer IS2 in the second direction X2, and may be in contact with the second inner spacer IS2 in the third direction X3.

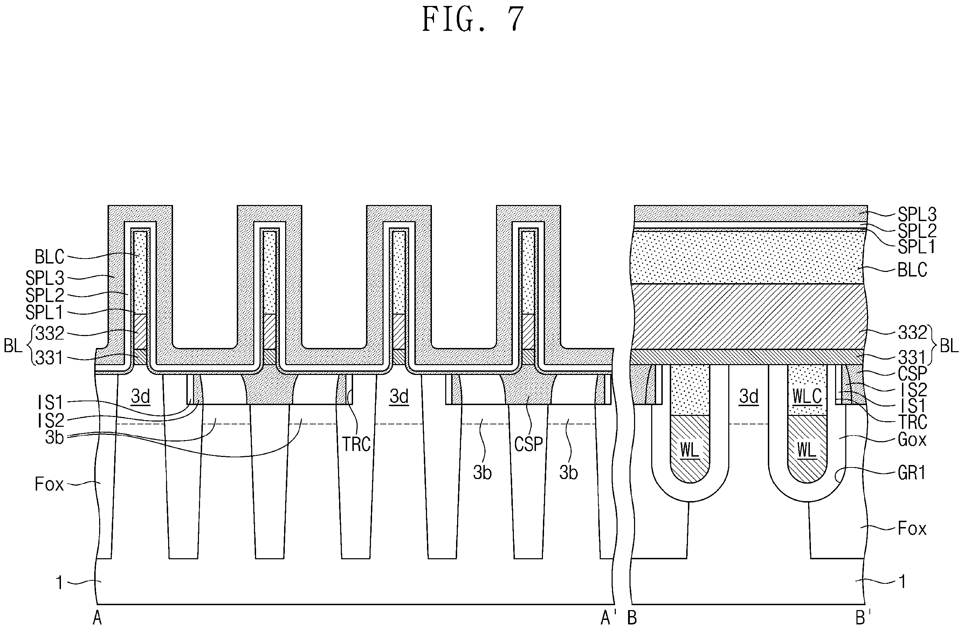

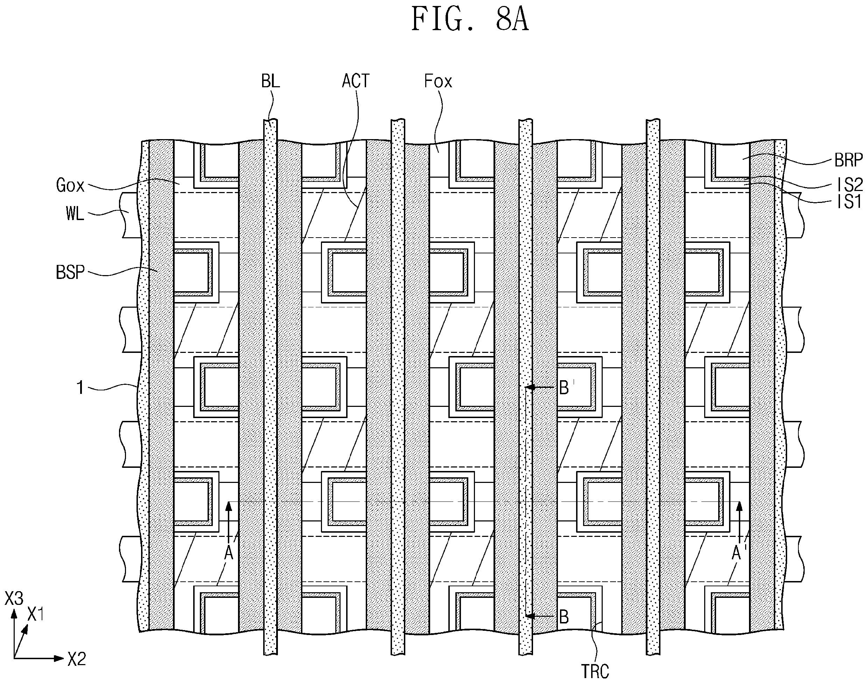

Referring to FIGS. 7 and 8A, a first metal layer, a second metal layer, and a bit line capping layer may be sequentially stacked on the entire surface of the substrate 1 and then etched to form bit lines BL and a bit line capping pattern BLC. The bit lines BL may include a first bit line metal pattern 331 and a second bit line metal pattern 332 sequentially stacked. In the etching process of forming the bit lines BL, the substrate 1 and the device isolation part Fox on both sides of the bit lines BL, and portions of the inner spacers IS1 and IS2, buried sacrificial layer BRP, interlayer insulating layer CSP may also be etched to form a recess region. After forming the bit lines BL, first to third sub bit line spacer layers SPL1, SPL2, and SPL3 may be sequentially stacked on the entire upper surface of the substrate 1 and conform to components thereon.

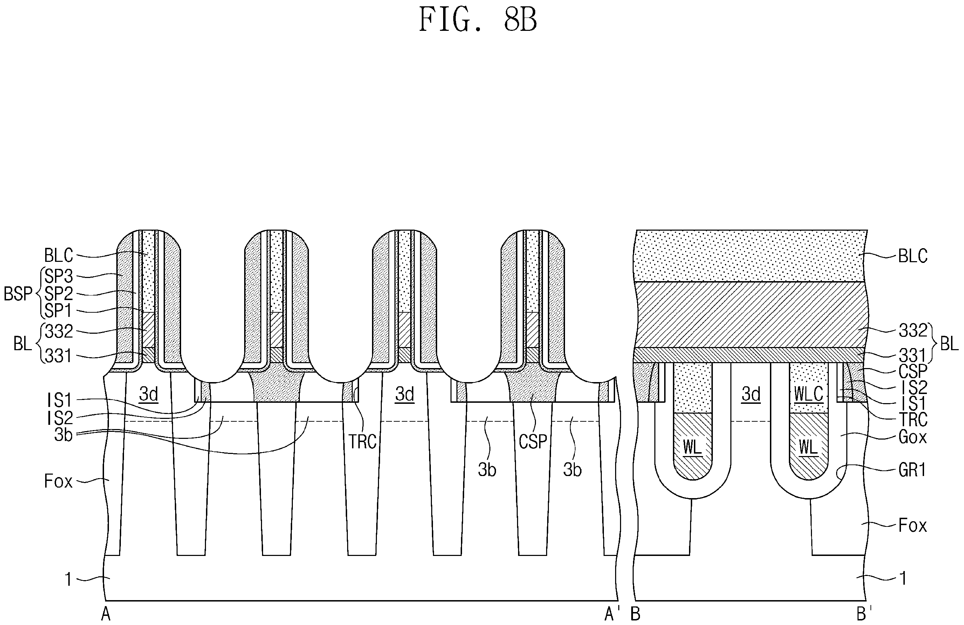

Referring to FIGS. 8A and 8B, an etching process may be performed on the first to third sub bit line spacer layers SPL1, SPL2, and SPL3 to form a bit line spacer BSP that covers sidewalls of the bit lines BL and the bit line capping pattern BLC and to expose an upper surface of the bit line capping pattern BLC. In this case, upper surfaces of the device isolation part Fox between the bit line spacers BSP, inner spacers IS1 and IS2, and buried sacrificial layer BRP may be exposed. In addition, in this case, the device isolation part Fox, the inner spacers IS1 and IS2, and the upper portion of the buried sacrificial layer BRP may be also partially etched to round upper surfaces of the device isolation part Fox, inner spacers IS1 and IS2, and buried sacrificial layer BRP. The bit line spacer BSP may include first to third sub bit line spacers SP1, SP2, and SP3.

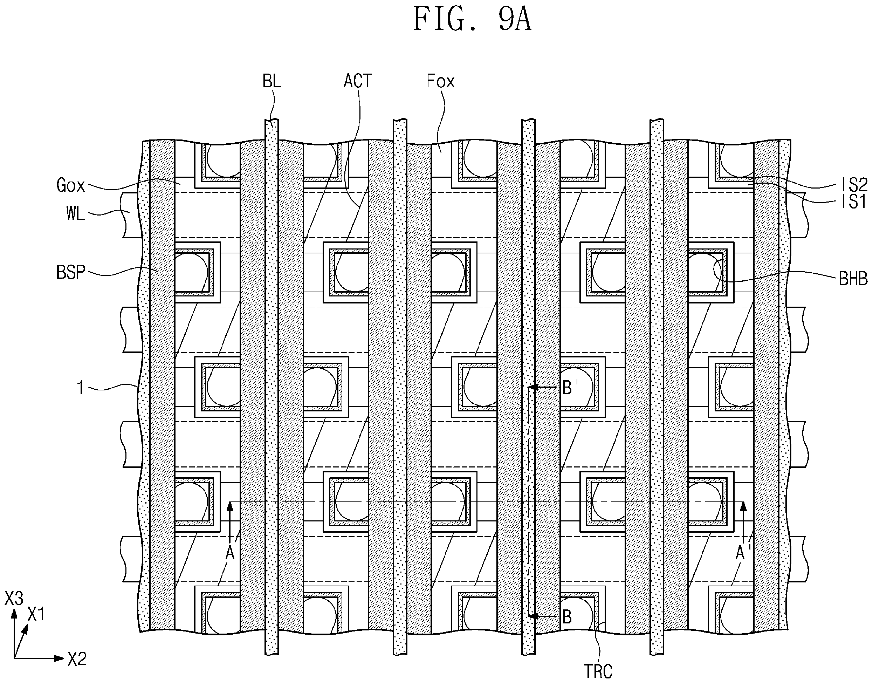

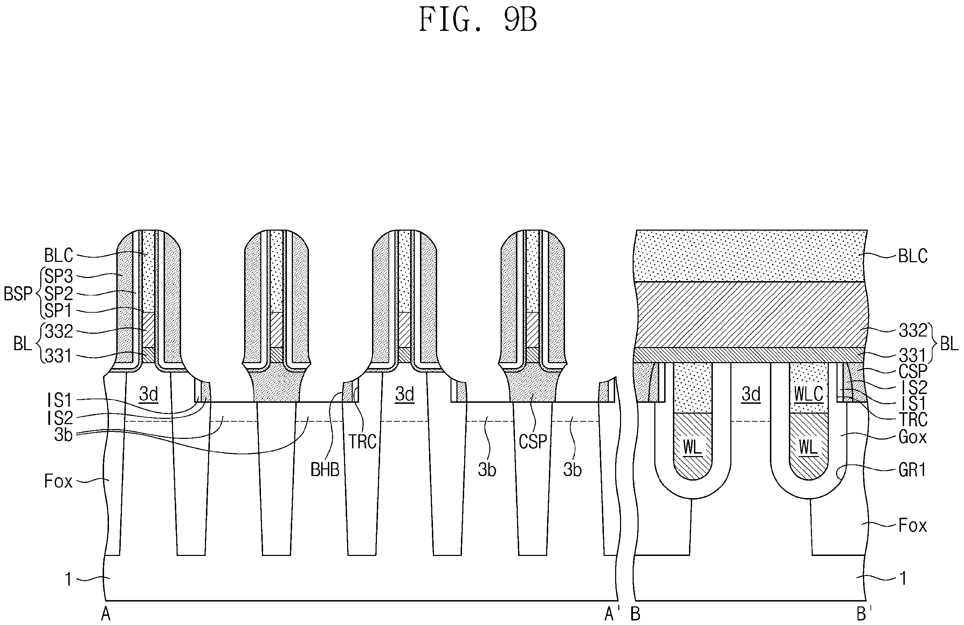

Referring to FIGS. 9A and 9B, the buried sacrificial layer BRP in the trench TRC may be removed to expose the second impurity region 3b. In this case, the second inner spacer IS2 and the interlayer insulating layer CSP have etch selectivity with the buried sacrificial layer BRP and are not etched. As a result, a lower hole BHB may be formed between the interlayer insulating layer CSP and the second inner spacer IS2. When forming the lower hole BHB, a lower portion of the bit line spacer BSP may also be partially etched.

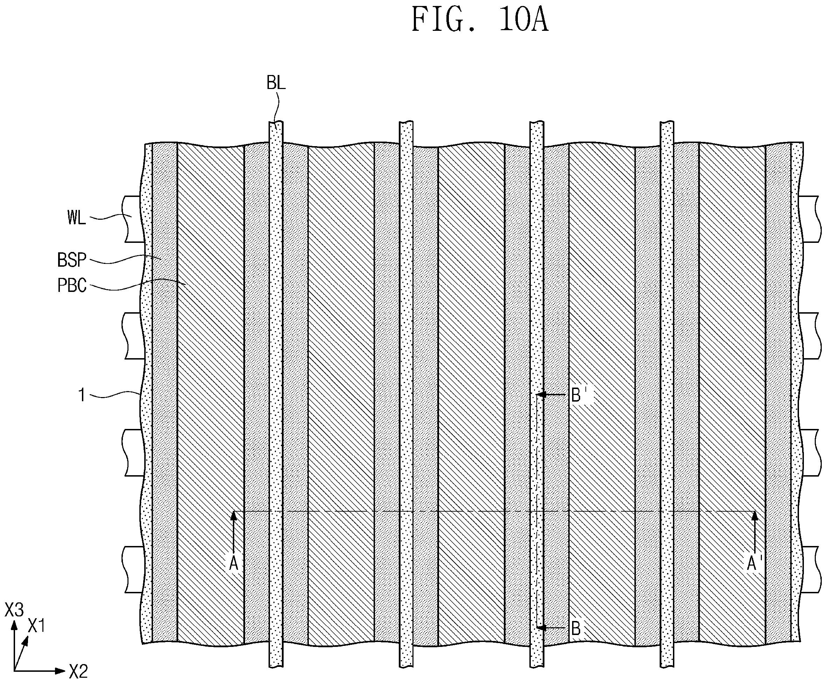

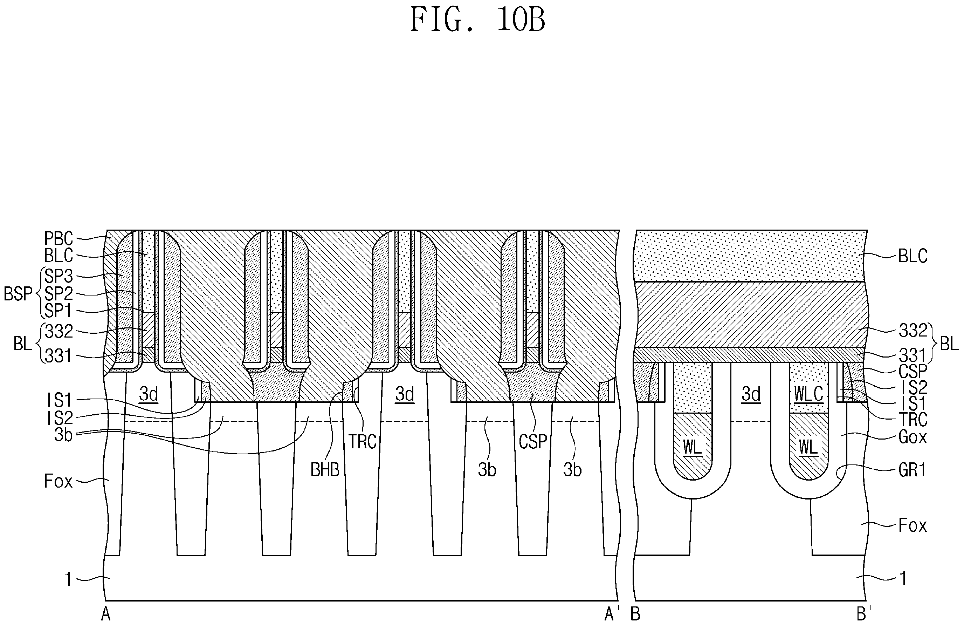

Referring to FIGS. 10A and 10B, a conductive layer may be stacked on the entire surface of the substrate 1, and a front surface etch-back process or a CMP process is performed to expose an upper surface of the bit line capping pattern BLC while a preliminary storage node contact PBC is formed between the bit lines BL. The preliminary storage node contact PBC may be formed to have a line shape that extends in the third direction X3 between the bit lines BL. The preliminary storage node contact PBC may be formed of a conductive layer, for example, polysilicon doped with impurities. The preliminary storage node contact PBC may be in (e.g., may fill) the lower hole BHB and may be in contact (e.g., direct contact) with the second impurity region 3b.

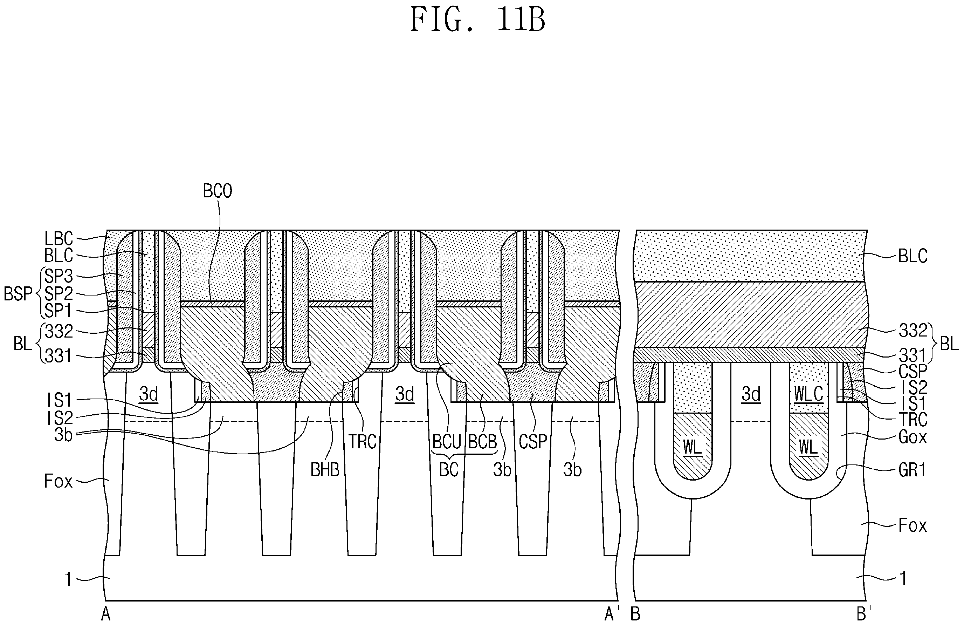

Referring to FIGS. 11A and 11B, the preliminary storage node contact PBC may be etched to form storage node contacts BC. In this case, the spare storage node contact PBC between the trenches TRC may be removed, but portions of the spare storage node contact PBC overlapping the trenches TRC may remain. Spaces between the storage node contacts BC may be filled with an insulating material to form storage node separation patterns SPP. The storage node separation patterns SPP may have a structure of at least one single layer or multilayer selected from among silicon oxide, silicon nitride, and silicon oxynitride. The storage node separation patterns SPP may be arranged in a row in the third direction X3 between the bit lines BL. The storage node separation patterns SPP may be formed outside the trench TRC. On the other hand, the lower portion BCB of the storage node contact BC may be in the trench TRC. Accordingly, a level of lower surfaces of the storage node separation patterns SPP may be higher than a level of lower surfaces of the storage node contact BC.

After forming the storage node separation patterns SPP, upper sidewalls of the bit line spacers BSP may be exposed by etching upper portions of the storage node contacts BC. An ohmic pattern BCO and a contact metal pattern LBC may be sequentially formed on the storage node contacts BC. A metal layer may be formed and then heat treatment may be performed to form metal silicide by reacting the metal layer with polysilicon constituting the storage node contact BC, and an unreacted metal layer may be removed. Alternatively, the ohmic pattern BCO may be formed by reacting a metal constituting the contact metal pattern LBC with polysilicon constituting the storage node contact BC.

Referring to FIGS. 12 and 1B, a metal layer may be deposited on the substrate 1 and then etched to form landing pads LP on the contact metal pattern LBC. In the etching process, upper portions of the bit line capping patterns BLC and upper portions of the bit line spacers BSP may also be partially removed. An insulating layer may be deposited in a space between the landing pads LP, and a CMP process may be performed to form a landing pad separation pattern LSP. As a result, the semiconductor memory device of FIGS. 1A and 1B may be manufactured.

In the fabricating method of the semiconductor memory device according to the present embodiment, the width W3 of the lower portion BCB of the storage node contact BC shown in FIG. 2B may be adjusted to a desired size by adjusting the thickness of the first and second inner spacers IS1 and IS2. In addition, as the buried sacrificial layer BRP is replaced with the spare storage node contact PBC in the steps of FIGS. 6B, 9B, and 10B, the spare storage node contact PBC may be formed in a self-aligned manner, thereby improving misalignment problems. Therefore, process defects may be reduced and yield may be improved. For example, with reference to FIG. 2B, the upper sidewall SW1 of the storage node contact BC is not vertically aligned with the lower sidewall SW2 of the storage node contact BC, wherein the upper sidewall SW1 and the lower sidewall SW2 are both on the common side of the storage node contact BC. Furthermore, the common side of the storage node contact BC has an inflection point IFP between the upper sidewall SW1 and the lower sidewall SW2. These features may reduce misalignment problems and increase a process margin in the fabrication process and a degree of freedom in constructing a routing structure. In addition, the lower portion BCB of the storage node contact BC is below the bit line spacer BSP. This may also reduce misalignment problems and increase a process margin in the fabrication process and a degree of freedom in constructing a routing structure. Moreover, since the second width W4 in the first direction X2 of the upper portion BCU of the storage node contact BC is greater than the first width W3 of the lower portion BCB of the storage node contact BC in the first direction X2, this may also reduce misalignment problems and increase a process margin in the fabrication process and a degree of freedom in constructing a routing structure. With reference to FIG. 1B, the lower sidewall SW2 of the storage node contact BC is not vertically aligned with the sidewall BCO_S of the ohmic pattern BCO. This may also reduce misalignment problems and increase a process margin in the fabrication process and a degree of freedom in constructing a routing structure.

In methods of fabricating semiconductor memory devices according to some embodiments of the present disclosure, because no bit line contact plug is formed, an aspect ratio may be reduced when compared to the conventional method, and thus it may be easier to form the storage node separation patterns SPP. Thus, process defects may be reduced.

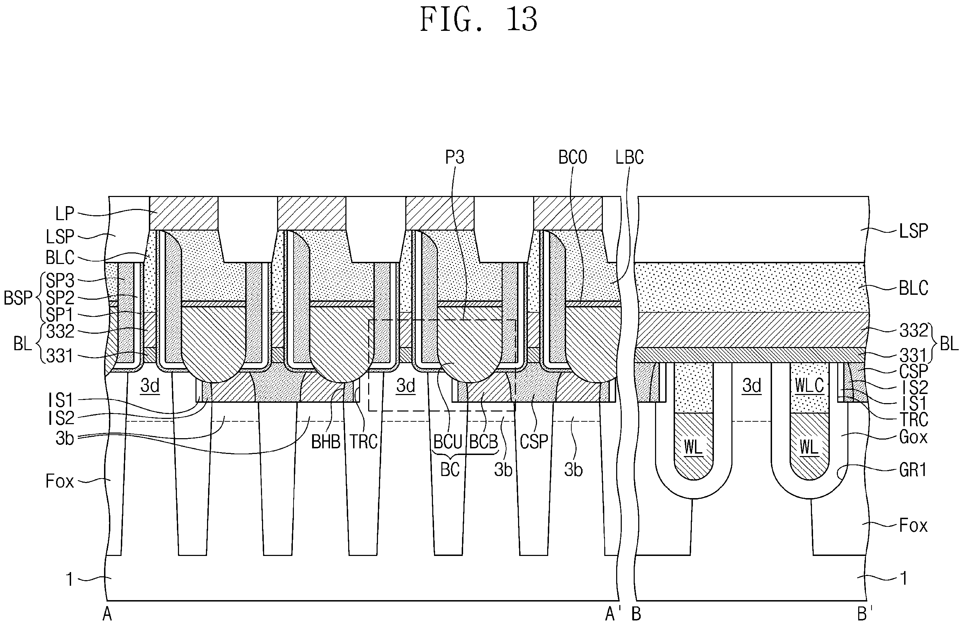

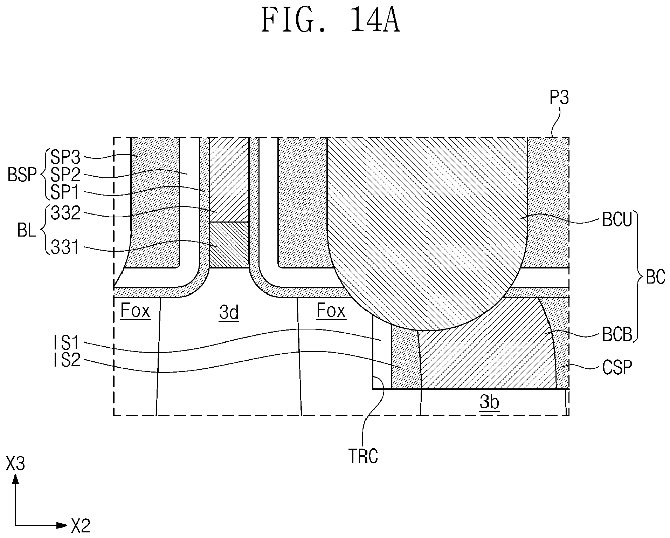

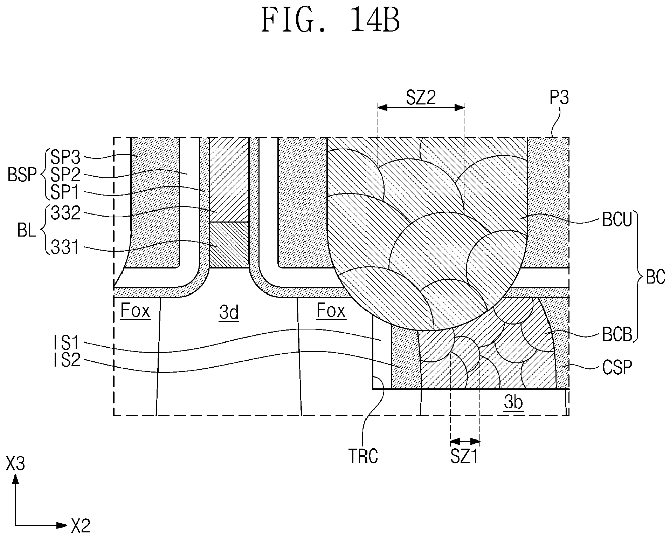

FIG. 13 is a cross-sectional view of FIG. 1A taken along line A-A' and line B-B' according to some embodiments of the present disclosure. FIGS. 14A and 14B are enlarged views of portion 'P3' of FIG. 13 according to some embodiments.

Referring to FIGS. 13 and 14A, in a semiconductor memory device according to some embodiments, a boundary surface exists between an upper portion BCU and a lower portion BCB of the storage node contact BC, and the upper portion BCU and the lower portion BCB are not integrally formed with each other. The upper portion BCU of the storage node contact BC may include a conductive material that is different from that of the lower portion BCB of the storage node contact BC. Alternatively, the upper portion BCU and lower portion BCB of the storage node contact BC may be formed of polysilicon and doped with impurities having the same or different concentrations.

The lower portion BCB of the storage node contact BC may also be referred to as a 'first silicon pattern'. The upper portion BCU of the storage node contact BC may also be referred to as a 'second silicon pattern'. A portion of the second silicon pattern BCU may be inserted into the first silicon pattern BCB. An end of the bit line spacer BSP may be partially interposed between the second silicon pattern BCU and the first silicon pattern BCB. A portion of the upper surface of the first silicon pattern BCB may in contact with the bottom surface of the bit line spacer BSP. Another portion of the upper surface of the first silicon pattern BCB may be round (or may be recessed/may have a curvature). Another portion of the upper surface of the first silicon pattern BCB may be lower than the bottom surface of the bit line spacer BSP. The upper surface of the first silicon pattern BCB may be lower than the upper surface of the substrate 1. A bottom surface of the second silicon pattern BCU may be lower than the upper surface of the substrate 1.

The lower surface of the first bit line metal pattern 331 may be higher than the lower surface of the first silicon pattern BCB. The lower surface of the first bit line metal pattern 331 may be in contact with the upper surface of the substrate 1. The lower surface of the first bit line metal pattern 331 may be positioned at the same level as the upper surface of the substrate 1. The lower surface of the first bit line metal pattern 331 may be coplanar with the upper surface of the substrate 1.

In some embodiments, referring to FIG. 14B, the first silicon pattern BCB may include first silicon grains having a first average grain size SZ1. The second silicon pattern BCU may include second silicon grains having a second average grain size SZ2 greater than the first average grain size SZ1. The use of second silicon grains of a greater grain size for the second silicon pattern BCU may reduce an electrical contact resistance of the storage node contact BC. Alternatively, the first silicon pattern BCB may have a monocrystalline silicon structure, and the second silicon pattern BCU may have a polycrystalline silicon structure. Other structures may be the same/similar to those described above.

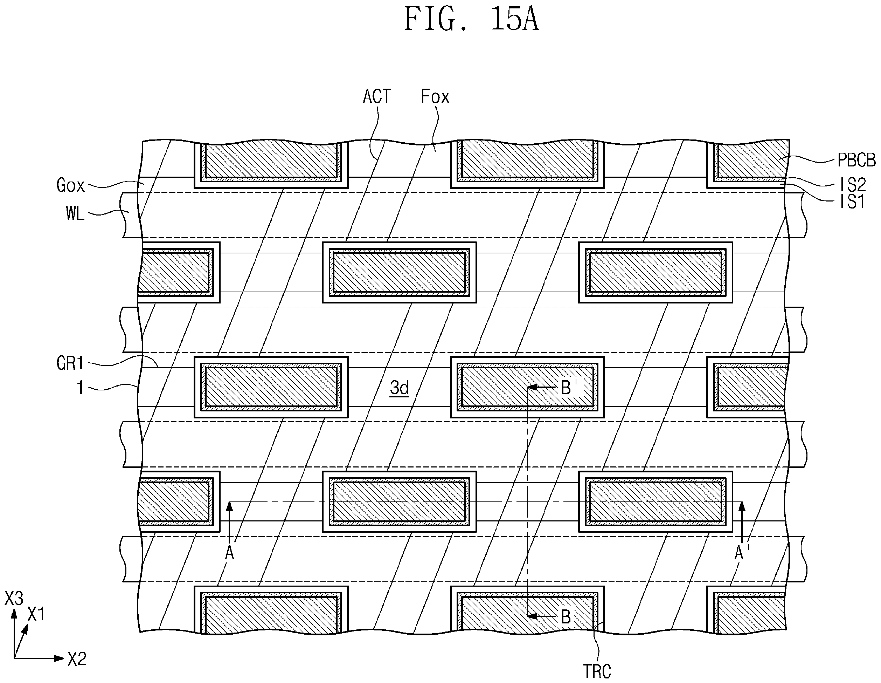

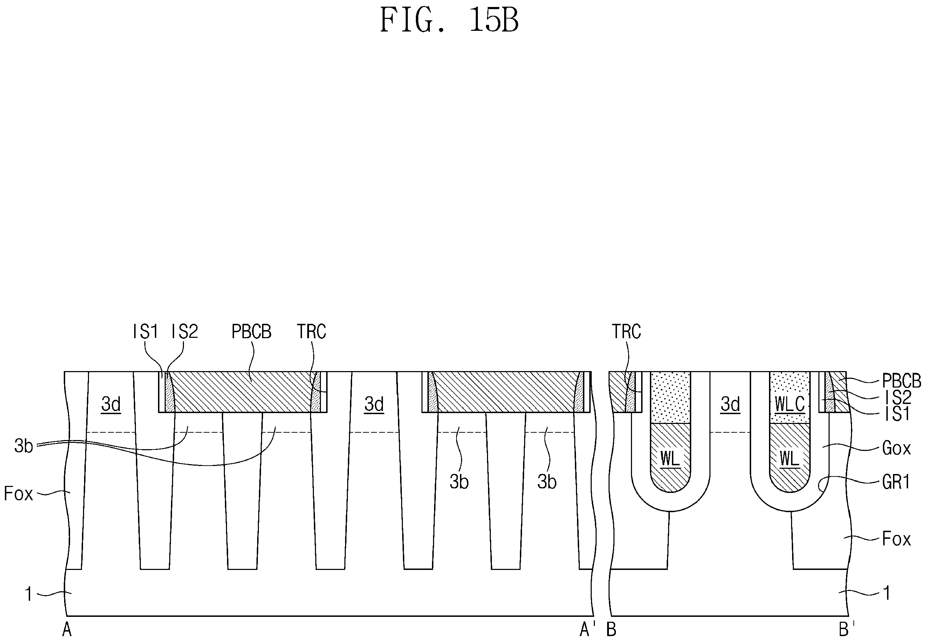

FIGS. 15A, 16A, and 17A are plan views illustrating a process of fabricating a semiconductor memory device according to some embodiments of the present disclosure. FIGS. 15B to 17B are cross-sectional views taken along lines A-A' and B-B' of FIGS. 15A, 16A, and 17A illustrating a process of fabricating a semiconductor memory device according to some embodiments of the present disclosure. Reference is made to FIGS. 3A-12 described above, with some duplicative description omitted herein in the interest of brevity.

Referring to FIGS. 15A and 15B, after the steps of FIGS. 4A and 4B, first inner spacers IS1 may be formed that may cover inner walls of the trenches TRC. A second inner spacer IS2 may be formed that may cover the sidewall of the first inner spacer IS1. After filling the trenches TRC with a preliminary lower contact pattern PBCB, a front surface etch-back process or a chemical mechanical polishing (CMP) process may be performed to remove the mask pattern MK of FIGS. 4A and 4B and to expose the device isolation part Fox and the upper surface of the substrate 1. As a result, the first and second inner spacers IS1 and IS2 and the preliminary lower contact pattern PBCB may be formed in the trenches TRC. An outer wall of the second inner spacer IS2 may be formed to be rounded. The preliminary lower contact pattern PBCB may have etch selectivity with at least the second inner spacer IS2 and may be formed of a conductive material. The preliminary lower contact pattern PBCB may be formed of polysilicon doped with impurities.

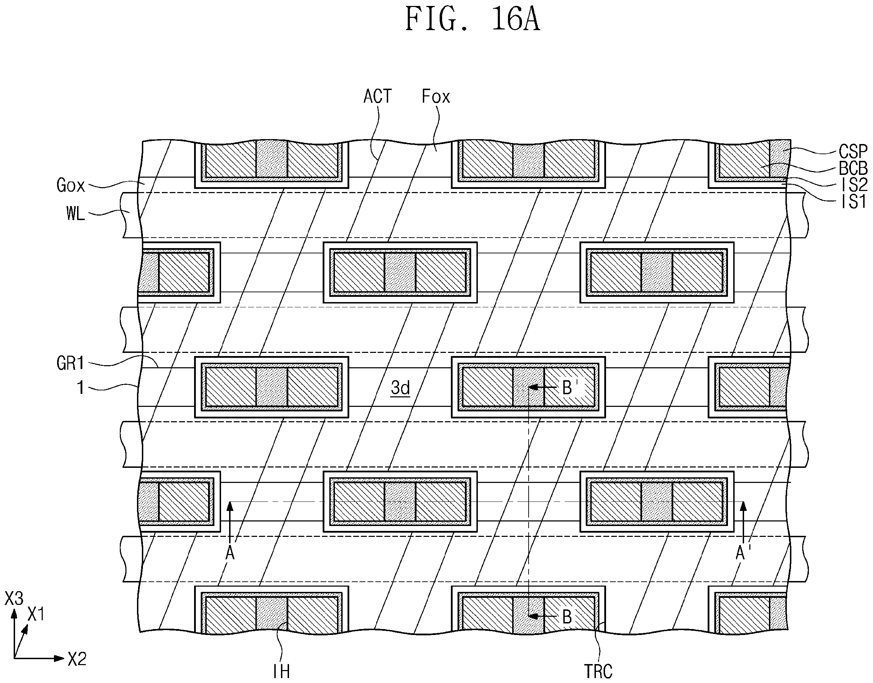

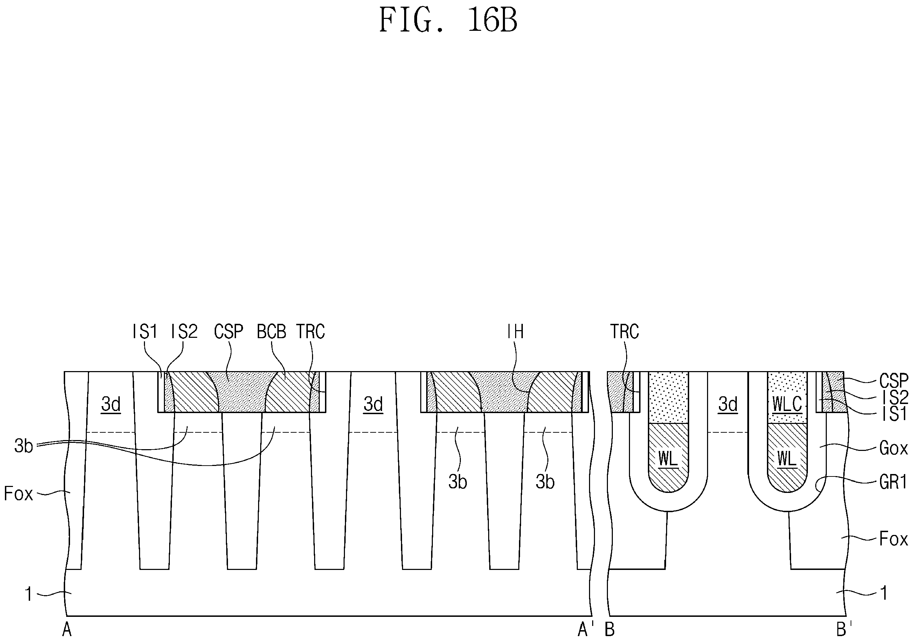

Referring to FIGS. 16A and 16B, portions of the preliminary lower contact pattern PBCB may be etched to form two first silicon patterns BCB at a center of the trench TRC. For example, an inner hole IH exposing the device isolation part Fox may be formed between the first silicon patterns BCB. After filling the inner hole IH with an insulating material, an etch-back may be performed to form an interlayer insulating layer CSP. The interlayer insulating layer CSP may be formed of a material such as silicon nitride. The interlayer insulating layer CSP may be spaced apart from the second inner spacer IS2 in the second direction X2 but is in contact with the second inner spacer IS2 in the third direction X3.

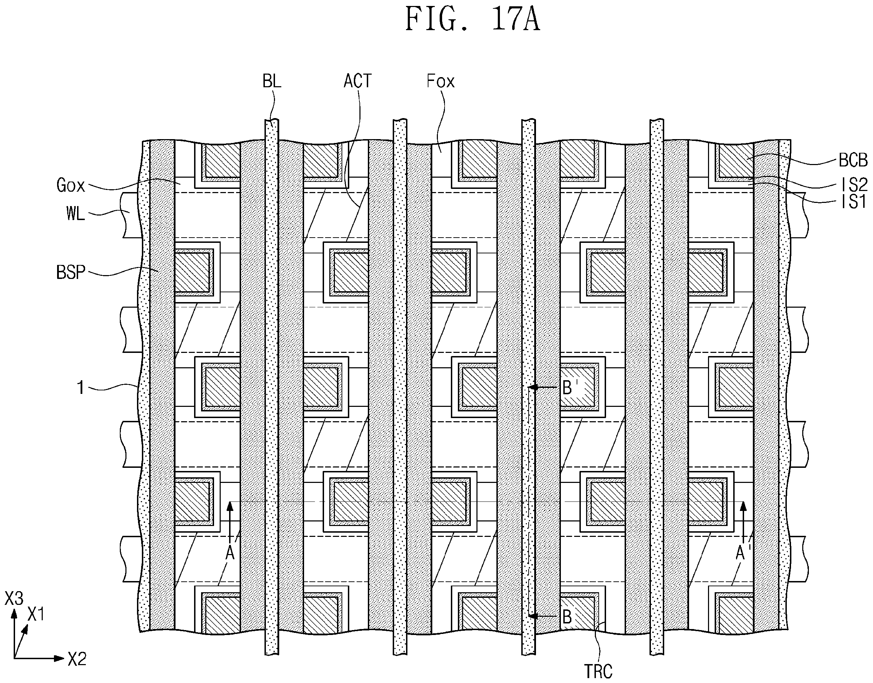

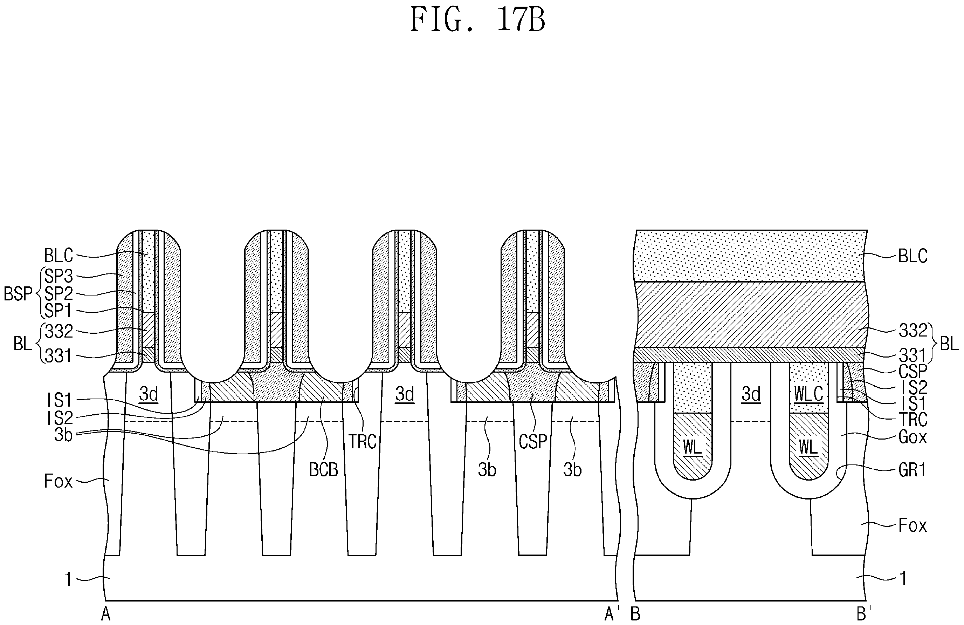

Referring to FIGS. 7, 17A, and 17B, a first metal layer, a second metal layer, and a bit line capping layer may be sequentially deposited on the entire surface of the substrate 1 and then etched to form bit lines BL and bit lines. A capping pattern BLC may be formed. The bit lines BL include a first bit line metal pattern 331 and a second bit line metal pattern 332 sequentially stacked. In the etching process of forming the bit lines BL, portions of the substrate 1 on both sides of the bit lines BL, device isolation part Fox, inner spacers IS1 and IS2, first silicon patterns BCB, and interlayer insulating layer CSP may be etched to form a recess region. After forming the bit lines BL, first to third sub bit line spacer layers SPL1, SPL2, and SPL3 may be sequentially deposited on the entire upper surface of the substrate 1 and may conform to components thereon.

Referring to FIGS. 17A and 17B, an etching process may be performed on the first to third sub bit line spacer layers SPL1, SPL2, and SPL3 to form a bit line spacer BSP covering sidewalls of the bit lines BL and bit line capping pattern BLC and to expose an upper surface of the bit line capping pattern BLC. For example, upper surfaces of the device isolation part Fox between the bit line spacers BSP, inner spacers IS1 and IS2, and first silicon patterns BCB may be exposed. In addition, upper portions of the device isolation part Fox, inner spacers IS1 and IS2, and first silicon patterns BCB may be also partially etched, and the upper surfaces of the device isolation part Fox, internal spacers IS1 and IS2, and first silicon patterns BCB may be rounded. The bit line spacer BSP may include first to third sub bit line spacers SP1, SP2, and SP3.

Referring to FIGS. 10A and 10B, a conductive layer may be deposited on the entire surface of the substrate 1, and a front surface etch-back process or CMP process is performed to expose the upper surface of the bit line capping pattern BLC. A preliminary storage node contact PBC is formed between the bit lines BL. The preliminary storage node contact PBC may be formed to have a line shape extending in the third direction X3 between the bit lines BL. The preliminary storage node contact PBC may be formed of a conductive layer, for example, polysilicon doped with impurities. The preliminary storage node contact PBC is in contact with the first silicon patterns BCB of FIG. 17B.

Subsequently, referring to FIGS. 11A, 11B, and 13, the preliminary storage node contact PBC may be etched to form second silicon patterns BCU. The first silicon patterns BCB and the second silicon patterns BCU may form storage node contacts BC. Storage node separation patterns SPP are formed between the storage node contacts BC.

In some embodiments, an annealing process for crystallizing the first silicon pattern BCB and the second silicon pattern BCU may be separately performed. In some embodiments, an annealing process of the first silicon pattern BCB and the second silicon pattern BCU may be simultaneously performed. In some embodiments, an, a first annealing process for crystallizing the first silicon pattern BCB and a second annealing process for crystallizing the second silicon pattern BCU may be performed separately from each other. As shown in FIG. 14B, first and second silicon grains may be formed by the annealing process. Other fabricating processes may be as described above.

In methods of fabricating the semiconductor memory devices according to some embodiments of the present disclosure, the first silicon patterns BCB of the storage node contact BC may be formed in advance, and thus a misalignment margin may be secured when the second silicon patterns BCU are formed. Accordingly, process defects may be reduced and yield may be improved.

In semiconductor memory devices according to the present disclosure, the bit line BL may be in direct contact with the first impurity region without a bit line contact plug being disposed therebetween. As a result, it is not necessary to form a bit line contact plug, which simplifies the fabricating process and reduces the difficulty of the process. In addition, as there is no bit line contact plug disposed between the bit line BL and the first impurity region, the path between the bit line and the first impurity region may be shortened, the electrical resistance may be reduced, the bit line necking cut or the bit line to buried contact disturb (BBD) defects may be improved, thereby improving the reliability of the semiconductor memory devices.

In addition, in semiconductor memory devices according to the present disclosure, the level of the upper end of the first impurity region 3d may be higher than the level of the upper end of the second impurity region 3b. Accordingly, the BBD defects may be improved, and reliability of the semiconductor memory device may be improved.

In the method of fabricating the semiconductor memory device according to the present disclosure, it may be relatively easy to adjust the width of the bottom of the storage node contact, and problems related to misalignment may be solved or lessened by forming the storage node contact in the self-aligning manner. This may reduce process defects and improve yield.

While some embodiments of the inventive concepts provided herein are described above, a person skilled in the art may understand that many modifications and variations are made without departing from the scope of the present disclosure defined in the following claims. Accordingly, the examples of embodiments of the present disclosure should be considered in all respects as illustrative and not restrictive, with the scope of the present disclosure being indicated by the appended claims. The embodiments of FIGS. 1A through 17B and aspects thereof may be combined with each other.

## Claims

1. A semiconductor memory device comprising:
a device isolation part (Fox) on a substrate (1), the device isolation part (Fox) defining a first active portion (ACT(1)) and a second active portion (ACT(2)), a center portion of the first active portion (ACT(1)) adjacent in a first direction (X2) to an edge portion of the second active portion (ACT(2));
a first impurity region (3d) in the center portion of the first active portion (ACT(1));
a second impurity region (3b) in the edge portion of the second active portion (ACT(2));
a first bit line (BL(1)) in direct contact with the first impurity region (3d) and crossing the substrate (1) in a second direction (X3), the second direction (X3) intersecting the first direction (X2); and
a storage node contact (BC) in contact with the second impurity region (3b),
wherein an upper end of the first impurity region (3d) is higher than an upper end of the second impurity region (3b), and
wherein an upper sidewall (SW1) of the storage node contact (BC) is not vertically aligned with a lower sidewall (SW2) of the storage node contact (BC), the upper sidewall (SW1) and the lower sidewall (SW2) both on a common side of the storage node contact (BC).

2. The semiconductor memory device of claim 1, further comprising:
a second bit line (BL(2)) extending in the second direction (X3) and spaced apart from the first bit line (BL(1)) in the first direction (X2), the storage node contact (BC) interposed between the second bit line (BL(2)) and the first bit line (BL(1)); and
a bit line spacer (BSP) interposed between the second bit line (BL(2)) and the storage node contact (BC),
wherein a lower portion (BCB) of the storage node contact (BC) is below the bit line spacer (BSP).

3. The semiconductor memory device of claim 2, further comprising an interlayer insulating layer (CSP) interposed between the second bit line (BL(2)) and the device isolation part (Fox),
wherein an upper portion of the interlayer insulating layer (CSP) has a first width (W1), and
wherein a lower portion of the interlayer insulating layer (CSP) has a second width (W2) smaller than the first width (W1).

4. The semiconductor memory device of any preceding claim, wherein the common side of the storage node contact (BC) has an inflection point (IFP) between the upper sidewall (SW1) and the lower sidewall (SW2).

5. The semiconductor memory device of any preceding claim, wherein the storage node contact (BC) has an upper portion (BCU) and a lower portion (BCB),
wherein the lower portion (BCB) of the storage node contact (BC) includes first silicon grains having a first average grain size, and
wherein the upper portion (BCU) of the storage node contact (BC) includes second silicon grains having a second average grain size greater than the first average grain size.

6. The semiconductor memory device of any preceding claim, wherein the device isolation part (Fox) is interposed between the first impurity region (3b) and the second impurity region (3d), and
wherein the semiconductor memory device further comprises a separation spacer (IS 1, IS2) interposed between an upper sidewall of the device isolation part (Fox) and a lower portion (BCB) of the storage node contact (BC).

7. The semiconductor memory device of claim 6, wherein the separation spacer (IS 1, IS2) includes:
a first separation spacer (IS 1) in contact with an upper sidewall of the device isolation part (Fox); and
a second separation spacer (IS2) interposed between the first separation spacer and a lower portion (BCB) of the storage node contact (BC),
wherein the second separation spacer (IS2) includes a material different from a material of the first separation spacer (IS 1).

8. The semiconductor memory device of any preceding claim, wherein a lower portion (BCB) of the storage node contact (BC) has a first width (W3) in the first direction (X2), and
wherein an upper portion (BCU) of the storage node contact (BC) has a second width (W4) greater than the first width (W3) in the first direction (X2).

9. The semiconductor memory device of any preceding claim, further comprising:
a contact metal pattern (LBC) on the storage node contact (BC);
an ohmic pattern (BCO) between the contact metal pattern (LBC) and the storage node contact (BC); and
a landing pad (LP) on the contact metal pattern (LBC),
wherein the lower sidewall (SW2) of the storage node contact (BC) is not vertically aligned with a sidewall (BCO_S) of the ohmic pattern (BCO).

10. The semiconductor memory device of any preceding claim, further comprising a bit line spacer (BSP) interposed between the first bit line (BL(1)) and the storage node contact (BC),
wherein the bit line spacer (BSP) includes first, second, and third sub-spacers (SP1, SP2, SP3) sequentially on sidewalls of the first bit line (BL(1)),
wherein the first and second sub-spacers (SP1, SP2) extend across a lower surface of the third sub-spacer (SP3).

11. The semiconductor memory device of claim 1, further comprising:
a second bit line (BL(2)) spaced apart from the first bit line (BL(1)) in the first direction (X2), the storage node contact (BC) interposed between the second bit line (BL(2)) and the first bit line (BL(1));
an interlayer insulating layer (CSP) interposed between the second bit line (BL(2)) and the device isolation part (Fox); and
a separation spacer (IS1, IS2) interposed between an upper sidewall of the device isolation part (Fox) and a lower portion (BCB) of the storage node contact (BC),
wherein a lower surface of the separation spacer (IS1, IS2) has a first level (LV2), and
wherein a lower surface of the interlayer insulating layer (CSP) has a second level (LV3) equal to or lower than the first level (LV2).
